# EUROPÄISCHE PATENTSCHRIFT

(11) **EP 3 100 310 B1**
(45) Veröffentlichungstag und Bekanntmachung des Hinweises auf die Patenterteilung: **07.07.2021**
(21) Anmeldenummer: 15708697.6
(22) Anmeldetag: 21.01.2015
(51) Int. Cl.: H01L 33/60, H01L 33/62, H05K 1/18, H05K 3/00

(54) **VERFAHREN ZUR HERSTELLUNG EINER LEITERPLATTE**
METHOD FOR PRODUCING A CIRCUIT BOARD
PROCÉDÉ DE PRODUCTION D'UNE CARTE DE CIRCUITS IMPRIMÉS

(30) Priorität: 29.01.2014 AT 500582014
(43) Veröffentlichungstag der Anmeldung: 07.12.2016
(73) Patentinhaber: AT & S Austria Technologie & Systemtechnik Aktiengesellschaft, 8700 Leoben (AT)
(72) Erfinder: LANGER, Gregor, A-9061 Wölfnitz (AT); DAMEJ, Mario, A-9131 Grafenstein (AT); LUTSCHOUNIG, Ferdinand, A-9170 Ferlach (AT)
(74) Vertreter: Patentanwaltskanzlei Matschnig & Forsthuber OG
(86) Internationale Anmeldenummer: PCT/AT2015/050019
(87) Internationale Veröffentlichungsnummer: WO 2015/113088

(56) Entgegenhaltungen:
- JP-A- 2003 031 914
- JP-A- 2007 189 006
- JP-A- 2012 044 102
- US-A1- 2009 014 749
- None

## Beschreibung

Die vorliegende Erfindung betrifft ein Verfahren zur Herstellung einer Leiterplatte mit zumindest einer Kavität zur Aufnahme einer elektronischen Komponente, wobei die Kavitätenwände eine reflektierende, insbesondere spiegelnde Reflektorschicht aufweisen.

Leiterplatten werden in der elektronischen Industrie zum hochintegrierten Verschalten elektronischer Komponenten auf engstem Raum verwendet. Neben der mechanischen Stützfunktion müssen Leiterplatten aufgrund der hohen Integration, die notwendig ist, um den Anforderungen der Miniaturisierung elektronischer Geräte gerecht zu werden, eine Reihe weiterer Funktionen erfüllen. Beispielsweise wird der Wärmeverteilung in der Leiterplatte bzw. die Ableitung von Wärme aus der Leiterplatte große Aufmerksamkeit geschenkt. Viele Anwendungen verwenden leistungsstarke LED-Komponenten, sogenannte Power-LEDs, die zunehmend auch Kavitäten in der Leiterplatte selbst integriert werden. Die Integration einer LED in die Leiterplatte gestattet eine gute Ableitung der von der LED gebildeten Wärme in die Leiterplatte, wo eine effiziente Verteilung der Wärme erfolgen kann, um Hitzeschäden im Bereich der LED möglichst zu vermeiden. Nachteilig hierbei ist jedoch, dass durch die räumliche Umfassung der LED durch die Kavitätenwände die Effizienz der LED hinsichtlich der Lichtausbeute vermindert wird.

Es wäre somit wünschenswert, die Kavitäten bzw. die Kavitätenwände für LED-Anwendungen mit einer stark reflektierenden und insbesondere spiegelnden Reflektorschicht zu versehen. Problematisch hierbei ist jedoch, dass sämtliche zum Ausbilden derartiger Reflektorschichten im Rahmen einer industriellen Fertigung von Leiterplatten in Betracht zu ziehenden Verfahren zu einem mehr oder weniger unspezifischen Auftrag der die Reflektorschichten bildenden Materialien, z.B. Lacke, Pigmente und/oder Metalle, auf die Leiterplatte führen. So werden Lacke und Pigmente beispielsweise aufgesprüht, sodass zumindest die die Kavitäten umgebenden Bereiche mit dem Lack verschmutzt werden. Dies ist besonders bei Leiterplatten für LED-Anwendungen problematisch, da LED-Chips in der Regel durch Drahtbondverfahren ankontaktiert werden, welche Verfahren eine besondere Oberflächenbehandlung der Leiterplatte erfordern, um entsprechenden Bondoberflächen bereitzustellen. Diese Bondoberflächen müssen für das Bonden der Komponenten zum einen frei von Verschmutzungen oder gar Überlagerungen durch andere Schichten bleiben und sind andererseits mechanisch sehr empfindlich, sodass diese Flächen nach Ihrer Herstellung besser weitgehend unangetastet bleiben sollen.

Aus dem Stand der Technik ist beispielsweise im Dokument JP 2012 044102 A ein Verfahren zur Herstellung einer Leiterplatte offenbart, bei dem zumindest eine Kavität zur Aufnahme einer optoelektronischen Komponente vorgesehen ist. Eine zuvor aufgebrachte temporäre Schutzschicht wird beim Herstellen der Kavität im Bereich dieser Ausnehmung durchdrungen. Die Kavitätenwände weisen eine reflektierende, insbesondere spiegelnde Reflektorschicht auf. Die JP 2012 044102 A offenbart jedoch nicht, dass die Reflektorschicht sowohl die temporäre Schutzschicht als auch die Kavitätenwände flächig bedeckt.

Der Erfindung liegt daher die Aufgabe zugrunde, ein Verfahren anzugeben, welches es ermöglicht, Reflektorschichten selektiv auf die Kavitätenwände aufzubringen, ohne Leiterbahnenstrukturen und insbesondere Bondoberflächen zu beschädigen.

Diese Aufgabe wird mit einem Verfahren der eingangs genannten Art gelöst, wobei das Verfahren die folgenden Schritte umfasst:
Bereitstellen einer Leiterplatte,
Aufbringen einer temporären Schutzschicht auf zumindest einen Teilbereich der Oberfläche der Leiterplatte,
Herstellen der Kavität unter Durchdringung der Schutzschicht im Bereich der Kavität, Aufbringen der Reflektorschicht, wobei die Reflektorschicht sowohl die temporäre Schutzschicht als auch die Kavitätenwände flächig bedeckt, und
Entfernen der temporären Schutzschicht.

Gemäß der vorliegenden Erfindung wird eine Leiterplatte vor dem Herstellung der Kavität und somit auch vor dem Verspiegeln der Kavität mit einer temporären Schutzschicht versehen, die dazu gedacht ist, Leiterbahnen und vor allem empfindliche Bondoberflächen vor Beschmutzungen und Beschädigungen zu schützen. Die Reflektorschicht bedeckt flächig sowohl die temporäre Schutzschicht als auch die Kavitätenwände. Da die temporäre Schutzschicht beim Herstellen der Kavität von dem entsprechenden Werkzeug durchdrungen wird, reicht die temporäre Schutzschicht exakt bis an den Rand der Kavität heran, sodass tatsächlich nur die Kavitätenwände mit der Reflektorschicht beschichtet werden. Die temporäre Schutzschicht wird nach Fertigstellung der verspiegelten Kavitäten entfernt, wodurch die empfindlichen Oberflächen wieder freigelegt und somit für die weitere Bearbeitung der Leiterplatte zur Verfügung stehen. In aller Regel erfolgt hierauf die Weiterverarbeitung in Form der Bestückung der verspiegelten Kavitäten mit den LED-Chips, die mittels Drahtbondverfahren ankontaktiert werden.

In diesem Zusammenhang ist das erfindungsgemäße Verfahren bevorzugt dahingehend weitergebildet, dass eine Leiterplatte mit strukturierten Bondoberflächen für elektronische Komponenten bereitgestellt wird. Obwohl Bondoberflächen für elektronische Komponenten, wie beispielsweise LED-Chips, im Vergleich zu herkömmlichen Leiterzügen aus Kupfer relativ empfindlich sind und vor allem empfindlich gegenüber mechanischen Einflüssen sind, widerstehen sie dem Aufbringen und Entfernen einer temporären Schutzschicht, wie sie bei der vorliegenden Erfindung zum Einsatz gelangen soll, ohne Weiteres und können nach dem Entfernen der temporären Schutzschicht zum Ankontaktieren mittels Drahtbondverfahren herangezogen werden.

Wie bereits eingangs erwähnt, entstehen in einer Leiterplatte aufgrund der hohen Integration der elektronischen Komponenten, die allesamt naturgemäß eine gewisse Abwärme produzieren und insbesondere bei Verwendung von leistungsstarken LED-Chips große Wärmemengen, die vor allem bei den genannten LED-Chips sehr punktuell auftreten und daher zur Vermeidung von Wärmespitzen in der Leiterplatte effektiv verteilt werden müssen, um eine akzeptable Lebensdauer der Leiterplatte zu gewährleisten. Gemäß einer bevorzugten Ausführungsform der vorliegenden Erfindung ist das erfindungsgemäße Verfahren daher bevorzugt dahingehend weitergebildet, dass als Leiterplatte eine IMS-Leiterplatte bereitgestellt wird. Die Abkürzung IMS steht für Insulated Metal Substrate und bezeichnet Ausgangsmaterialen für Leiterplatten, bei denen eine Isolierschicht, beispielsweise bestehend aus mit thermisch leitfähigen Partikeln (z.B. Aluminiumoxid, Aluminiumnitrid) gefüllten Epoxidharz, zwischen einer dünnen Metallschicht zur Ausbildung der Leiterzüge und einer relativen dicken Metallplatte angeordnet ist, welche Metallplatte sehr effektiv Wärme über die gesamte Fläche der Platte verteilen kann. Die Verwendung einer IMS-Leiterplatte zur Aufnahme von LED-Chips in Kavitäten stellt somit hinsichtlich der Verteilung der Wärme eine überaus günstige Option dar, wobei jedoch dann, wenn die den LED-Chip enthaltende Kavität nicht erfindungsgemäß verspiegelt ist, eine relativ geringe Lichtausbeute resultiert. Dies liegt darin begründet, dass die Schnittflächen der Kavität, d.h. die Kavitätenwände, die in aller Regel aus Aluminium oder Kupfer bestehen, ein relatives geringes Reflexionsvermögen besitzen. Dieser Nachteil der Verwendung einer IMS-Leiterplatte zur Aufnahme von LED-Chips in Kavitäten wird somit mit der vorliegenden Erfindung optimal wettgemacht, da die per se schlecht reflektierenden bzw. gar nicht spiegelnden Kavitätenwände mit einer entsprechenden Reflektorschicht versehen werden können, ohne eventuell auf der Leiterplattenoberfläche vorhandene Bondoberflächen beim Herstellen der Reflektorschicht zu beschädigen.

Da es mit der vorliegenden Erfindung gelingt, eine hocheffiziente Reflektorschicht auf Kavitätenwände aufzubringen, ist es nicht notwendig, bei der Herstellung der Kavität, besondere Maßnahmen zur Optimierung des Reflexionsvermögens der Kavitätenwände zu ergreifen. Gemäß einer besonders einfachen und daher bevorzugten Ausführungsform der vorliegenden Erfindung kann somit insbesondere dergestalt vorgegangen werden, dass der Schritt des Herstellens der Kavität das Fräsen der Leiterplatte mit einem Fräskopf umfasst. Das Fräsen der Leiterplatte mit einem Fräskopf lässt sich in hervorragender Weise automatisieren, wobei der Fräskopf, der in der Lage ist, die Leiterplatte, und insbesondere eine IMS-Leiterplatte, zu fräsen, naturgemäß auch die temporäre Schutzschicht mit Leichtigkeit durchdringt und eine klare Schnittfläche der Schutzschicht herstellen kann, so dass eine optimale Begrenzung der Reflektorschicht auf die Kavitätenwände erreicht wird.

Gemäß einer bevorzugten alternativen Ausführungsform der vorliegenden Erfindung kann jedoch auch dergestalt vorgegangen werden, dass als Leiterplatte eine Leiterplatte aus einem Prepreg-Material bereitgestellt wird. Derartige Prepreg-Materialien, wie beispielsweise FR4, verfügen zwar über ein viel geringeres Wärmeleitvermögen als die vorgenannten IMS-Leiterplatten, sind jedoch weit verbreitet und bieten gegenüber IMS-Leiterplatten Vorteile hinsichtlich der relativ einfachen Realisierbarkeit von mehrschichtigen Leiterplattenaufbauten, was wiederum der in der elektronischen Industrie gewünschten Miniaturisierung der Leiterplatten entgegenkommt. Die Erfinder des vorliegenden erfindungsgemäßen Verfahrens haben herausgefunden, dass sich das Verfahren ohne Weiteres auch auf derartige Leiterplatten aus Prepreg-Materialien anwenden lässt.

In diesem Fall ist es bevorzugt, wenn der Schritt des Herstellens der Kavität das Schneiden der Leiterplatte mit einem Laserstrahl umfasst. Das Schneiden derartiger Leiterplatten mit einem Laserstrahl ist in der Leiterplattenindustrie ein gut erprobtes Standardverfahren und kann ohne Weiteres zur Herstellung von Kavitäten implementiert werden. Beispielsweise werden Prepreg-Leiterplatten mit CO2-Lasern geschnitten, wobei die Eindringtiefe des Lasers in die Leiterplatte durch das Vorsehen einer Laserstopplage aus Kupfer in der gewünschten Tiefe der Leiterplatte gesteuert werden kann. Der Laser muss somit nicht durch die Leiterplatte hindurch schneiden, sondern kann bis zu einer gewissen Tiefe schneiden, was das Laserschneidverfahren für das Ausbilden einer Kavität im Sinne einer Aushöhlung mit einem Boden in der Leiterplatte als Methode der Wahl erscheinen lässt.

Um das Ausbilden einer Kavität in einer derartigen Prepreg-Leiterplatte zu begünstigen, ist die Erfindung gemäß einer bevorzugten Ausführungsform dahingehend weitergebildet, dass die Leiterplatte eine über einer Laserstopplage angeordnete haftvermindernde Schicht aufweist. Wenn nun der Laser auf die Laserstopplage hin abschneidet und beispielsweise ein annähernd quaderförmiges Stück der Leiterplatte freistellt, kann dieses quaderförmige Stück durch die Wirkung der haftverminderten Schicht besonders leicht aus dem Volumen der Leiterplatte herausgenommen werden. In der Leiterplattentechnik sind derartige haftvermindernde Schichten bzw. haftvermindernde Materialien bekannt und bestehen insbesondere aus Al-, Mg-, Ca-, Na- oder Zn-Seifen zusammen mit einem Bindemittel und einem Lösungsmittel. Diese Materialien werden bereits standardmäßig verwendet, um Leiterplattenschichten, die frei geschnitten wurden, von den darunter liegenden Leiterplattenschichten zu lösen. Die Verwendung einer haftvermindernden Schicht ist beispielsweise aus der WO 2010/085830 A1 bekannt geworden.

Die für die vorliegende Erfindung so wesentliche temporäre Schutzschicht kann auf verschiedene Art und Weise auf die Leiterplatte aufgebracht werden. Gemäß einer bevorzugten Ausführungsform der vorliegenden Erfindung ist es jedoch vorgesehen, dass als temporäre Schutzschicht eine selbstklebende Folie aufgebracht wird, in welchem Fall die selbstklebende Folie bei nur geringem Druck und bei normaler Verarbeitungstemperatur der Leiterplatte auflaminiert werden kann.

Bevorzugt ist, dass die selbstklebende Folie eine Folie auf Polyethylenbasis mit einer Klebeschicht auf Kautschukbasis ist. Derartige Folien werden unter anderem als Laserschutzfolien verwendet und sind beispielsweise unter dem Namen Laserguard Light 3100H3 der Firma Nitto Denko bekannt. Ebenso fällt beispielsweise die Folie PF 32 C der Firma Poli-Film in diese Kategorie.

Gemäß einer alternativen bevorzugten Ausführungsform der vorliegenden Erfindung ist die selbstklebende Folie eine Folie auf PVC-Basis mit einer Klebeschicht auf Acrylatbasis. Derartige Folien sind als Oberflächenschutzfolien bekannt, die sich durch hervorragende Verformungseigenschaften auszeichnen und zum Schutz von Metalloberflächen bei Verformungs- oder Biegeprozessen verwendet werden. In dieser Kategorie ist die Folie SPV 224P der Firma Nitto Denko zu nennen, welche eine PVC-Folie mit druckempfindlichen Acrylatkleber ist und welche Schmiereigenschaften beim Fräsen zur Verfügung stellt.

Gemäß einer weiters bevorzugten Ausführungsform der vorliegenden Erfindung ist die selbstklebende Folie eine Folie auf Polyethylenbasis mit einer Klebeschicht auf Acrylatbasis, worunter beispielsweise die Folie PF 13 der Firma Poli-Film fällt.

Alle vorgenannten Folien werden in der Leiterplattenverarbeitung bereits standardmäßig eingesetzt und ihre Handhabung ist daher dem Fachmann geläufig.

Alternativ zu den vorgenannten selbstklebenden Folien ist jedoch auch eine Ausführungsform der vorliegenden Erfindung denkbar, bei der als temporäre Schutzschicht ein Lack auf Silikonbasis aufgebracht wird, der in einer dickeren Schicht aufgebracht werden und nach der Weiterverarbeitung der Leiterplatte, d.h. nach Herstellung der verspiegelten Kavitäten mechanisch durch Abziehen wieder entfernt werden kann.

Allen vorgenannten Varianten zur Bereitstellung bzw. zum Aufbringen einer temporären Schutzschicht ist gemeinsam, dass die Entfernung der temporären Schutzschicht mechanisch durch Abziehen erfolgen kann, da eine chemische Entfernung die Reflektorschicht in der Kavität und/oder die zu schützenden Oberflächen, und insbesondere die Bondoberflächen, angreifen würde.

Zur Herstellung der Reflektorschicht kann bevorzugt dergestalt vorgegangen werden, dass die Reflektorschicht aus einem Lack, ausgewählt aus der Gruppe bestehend aus Epoxidlacken und Acrylatlacken, gebildet wird. Epoxid- und Acrylatlacke sind ähnlich den in der Leiterplattenindustrie bekannten Lötstopplacken aufgebaut und können mit weißen Pigmenten oder Füllmaterialien gefüllt sein. Es können somit zum einen bekannte weiße Lötstopplacke verwendet werden, z.B. Lacke der Firmen Taiyo oder Huntsman (Probimer 77) oder speziell zum Ausbilden von Reflektorschichten hergestellt werden. Wesentlich ist jedoch, dass die Lacksysteme gegenüber UV-Licht und thermischer Belastung stabil sein müssen und nicht vergilben dürfen. Diese Lacke können mittels Sprühverfahren aufgebracht werden, wobei sie sehr fein zerstäubt werden und auch durch unterrichtete Beschichtung leicht die Kavitätenwände bedecken können.

Alternativ hierzu kann die Erfindung bevorzugt dahingehend weitergebildet sein, dass die Reflektorschicht als Metallschicht aus den Metallen ausgewählt aus der Gruppe bestehend aus Al, Ag und Rh auf die Leiterplatte aufgebracht wird. Diese Metallschichten bilden auf der Oberfläche einen Spiegel, wobei das eingestrahlte Licht gerichtet reflektiert wird. Die beste Reflexion im sichtbaren Wellenlängenbereich wird mit Silber erreicht. Aus Kostengründen wird jedoch oft Aluminium verwendet, welches ebenfalls akzeptable Reflexionseigenschaften aufweist. Silber kann chemisch auf Metallschichten abgeschieden werden, ist jedoch an der Atmosphäre aufgrund der Bildung von Silbersulfidschichten nicht stabil. Deshalb werden Silberreflektorschichten im Rahmen der vorliegenden Erfindung in der Regel mit Rhodium beschichtet, welches stabile Schutzschichten ausbildet, die die Reflexion des Lichts jedoch nicht behindern. Das Rhodium wird galvanisch aufgebracht.

Um die Reflexionseigenschaften der Reflektorschicht weiter zu verbessern, können auf die genannten Metallschichten dünne transparente Oxidschichten aufgebracht werden. Die Erfindung ist daher bevorzugt dahingehend weitergebildet, dass zusätzlich eine Schicht ausgewählt aus der Gruppe bestehend aus Siliziumoxid und Aluminiumoxid aufgebracht wird. Dies kann mittels physikalischer Gasphasenabscheidung im Vakuum geschehen (PVD-Beschichtung; PVD = Physical Vapor Deposition).

Eine besonders bevorzugte Vorgehensweise zum Aufbringen einer Reflektorschicht sieht vor, dass der Schritt des Aufbringens der Reflektorschicht die folgenden Schritte umfasst:
Lackieren der Kavität mit einem Glanzlack
Aufbringen einer Reflexionsschicht aus Metall auf den Glanzlack
Aufbringen einer Schutzschicht auf Hexamethyldisiloxanbasis auf die Reflexionsschicht.

Ein solches Verfahren wird bereits zur Herstellung von Reflektoren zum Beispiel für Fahrzeugscheinwerfer mit besonders hochwertigen optischen Oberflächen eingesetzt und können beispielsweise unter dem Handelsnamen ALUNOVA® der Firma OTEC bezogen und zur Herstellung von Leiterplatten implementiert werden. Der Glanzlack wird eingesetzt, um Unebenheiten der Oberfläche, beispielsweise der Fräskante der Kavität, auszugleichen und eine glatte Oberfläche auszuformen sowie eine bessere Haftung für die darauffolgende Reflexionsschicht, die zumeist aus Aluminium hergestellt ist, zu schaffen. Diese Glanzlacksysteme können durch Aufsprühen oder durch Abscheiden im anodischen Elektrotauchlackierverfahren aufgebracht werden. Das Aufbringen der hochreflektierenden Metallschicht, bevorzugt aus Reinstaluminium, geschieht im Vakuum durch Bedampfung bzw. Magnetron-Zerstäubung. Die Schutzschicht auf Hexamethylsiloxanbasis wird aufgebracht, um das Aluminium vor äußeren Einflüssen und vor allem korrosiven Angriff zu schützen und bietet eine langzeitbeständige, wischfeste siliziumorganische Schutzschicht mit hoher chemischer Barrierewirkung. Diese Schicht ist irisierungsfrei, nahezu porenfrei, und weist eine extrem geringe Lichtabsorption auf. Das Hexamethyldisiloxan wird durch Abscheidung in einem Mittelfrequenzvakuumverfahren durch Plasmapolymerisation abgeschieden und erzeugt eine glasartige Überzugsschicht auf der Oberfläche des zu beschichtenden Körpers.

Gemäß einer bevorzugten Ausführungsform der vorliegenden Erfindung ist es vorgesehen, dass beim Schritt des Herstellens der Kavität Abstand zu bestehenden Leiterzügen bzw. Bondoberflächen der Leiterplatte gehalten wird, was insbesondere dann wesentlich ist, wenn die Reflektorschicht aus einem elektrisch leitenden Material besteht. In diesem Fall darf die metallische und daher leitende Reflektorschicht nicht in Kontakt mit den Leiterzügen bzw. Bondoberflächen der Leiterplatte kommen, da es zu einem elektrischen Kurzschluss kommen würde. Wenn gemäß dieser bevorzugten Ausführungsform die Kavität mit einem gewissen Abstand zu bestehenden Leiterzügen bzw. Bondoberflächen der Leiterplatte hergestellt wird, um, wie dies beim vorliegenden erfindungsgemäßen Verfahren vorgesehen ist, das Aufbringen der Reflektorschicht in Gegenwart der temporären Schutzschicht vorzunehmen, ist sichergestellt, dass nach Entfernen der temporären Schutzschicht kein derartiger Kurzschluss ausgebildet wird, da die Schutzschicht die Leiterzüge bzw. Bondoberflächen entsprechend überlappt bzw. überragt.

Die Erfindung wird im Folgenden anhand eines in der Zeichnung schematisch dargestellten Ausführungsbeispiels näher erläutert. In dieser zeigen
die Fig. 1a - 1f eine erste bevorzugte Ausführungsform des erfindungsgemäßen Verfahrens und
die Fig. 2a - 2b eine alternative bevorzugte Ausführungsform des erfindungsgemäßen Verfahrens.

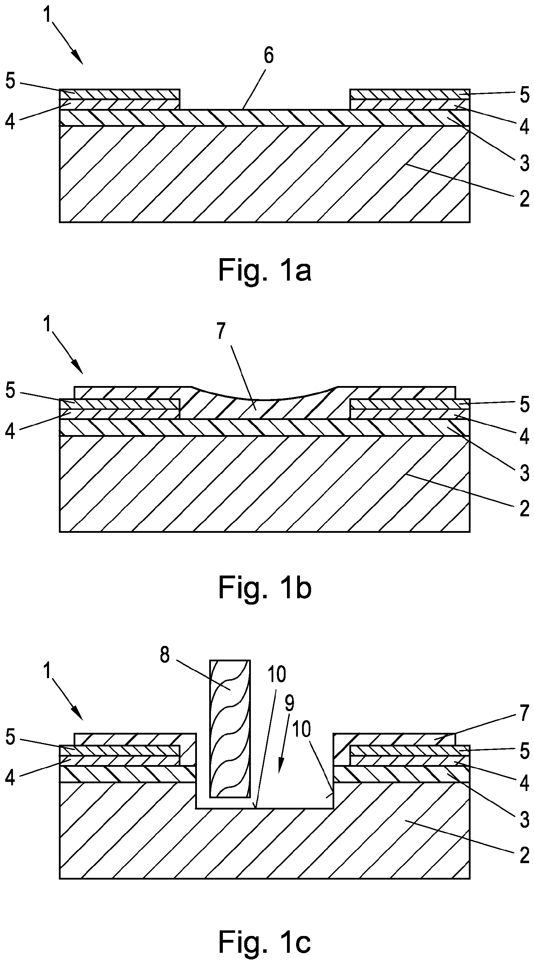

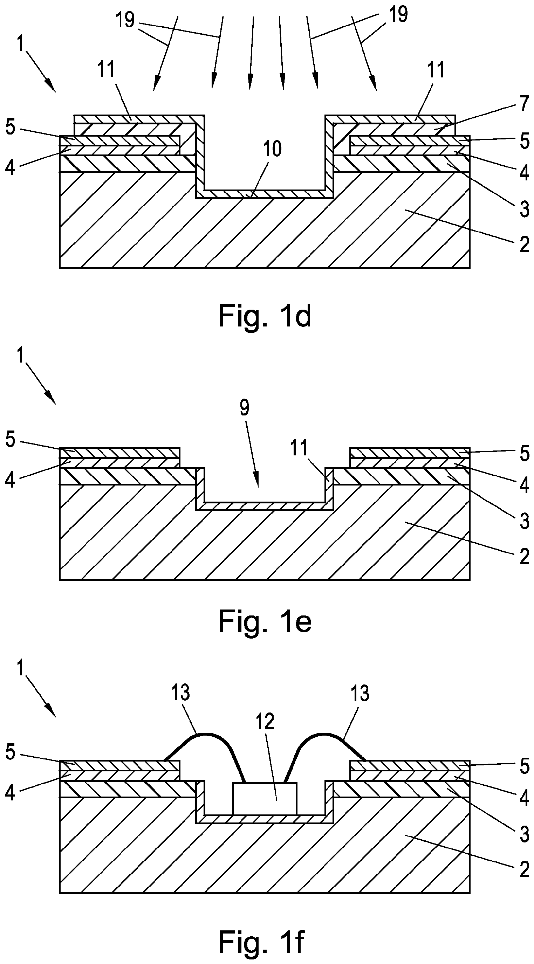

In Fig. 1a) ist eine Leiterplatte mit 1 bezeichnet, wobei die Leiterplatte 1 im vorliegenden Fall eine IMS-Leiterplatte (Insulated Metal Substrate) ist. Die IMS-Leiterplatte 1 zeichnet sich durch ein relativ dickes Metallsubstrat 2 aus, welches aus Kupfer oder Aluminium gefertigt sein kann und eine Dicke von mindestens 50 µm bis zu einigen Millimetern aufweisen kann. Auf die Substratschicht 2 folgt eine Isolierschicht 3, die in der Regel aus einem isolierenden, mit thermisch leitfähigen Partikeln gefüllten Harzsystem, beispielsweise Epoxidharz, besteht. Auf dieser Isolierschicht 3 sind Leiterzüge 4 sowie Goldoberflächen 5, die als Bondoberflächen dienen, angeordnet. Die Leiterplatte 1 ist somit bereit zur Aufnahme von LED-Chips, die beispielsweise an der Position 6 angebracht werden könnten, wobei die Kontaktierung eines LED-Chips auf die Bondoberflächen 5 erfolgen könnte. Im Rahmen der vorliegenden Erfindung, bei der eine Kavität hergestellt werden soll, wird nun eine temporäre Schutzschicht 7 auf die Leiterplatte 1 aufgebracht (Fig. 1b)), die die Bondoberflächen 5 bedeckt. Die temporäre Schutzschicht 7 könnte darüber hinaus die Leiterzüge 4 aus Kupfer bedecken, wenn diese nicht wie im vorliegenden Fall von Goldoberflächen 5 bedeckt wären. In Fig. 1c) ist nun zu erkennen, dass in der gemäß Fig. 1b) vorbereitenden Leiterplatte, beispielsweise mittels eines Fräskopfes 8, eine Kavität 9 hergestellt werden kann. Die Kavität 9 weist nach diesem Verfahrensschritt relativ schlecht reflektierende Kavitätenwände 10 auf. Gemäß Fig. 1d) wird nun die Reflektorschicht 11 aufgebracht, wie dies durch die Schar von Pfeilen 19 versinnbildlicht ist. Es ist zu erkennen, dass die Reflektorschicht 11 sowohl die temporäre Schutzschicht 7 als auch die Kavitätenwände 10 flächig bedeckt. Nach der Entfernung der temporären Schutzschicht 7 (Fig. 1e)) wird nun eine Leiterplatte mit einer verspiegelten Kavität 9 erhalten, wobei die Reflektorschicht 11 nur das Innere der Kavität 9 auskleidet. In die verspiegelte Kavität 9 kann nun ein LED-Chip 12 eingesetzt werden, der über Bonddrähte 13 an die Bondoberfläche 5 ankontaktiert werden kann (Fig. 1f)).

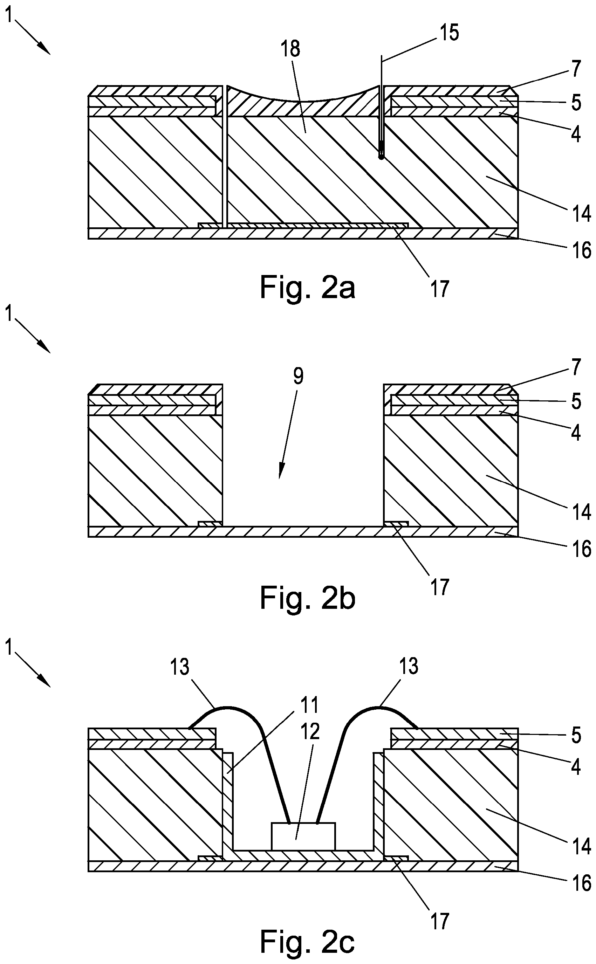

In Fig. 2a ist wiederum eine Leiterplatte 1 zu erkennen, die jedoch im vorliegenden Fall keine IMS-Leiterplatte sondern eine Leiterplatte aus einem hinlänglich bekannten, glasfaserverstärkten Epoxidharz (z.B. FR4) ist. Die FR4-Schicht bzw. Prepreg-Schicht ist hierbei mit 14 bezeichnet, wobei wiederum Kupferlagen 4 und Bondoberflächen 5 auf der Leiterplatte 1 vorliegen. Mit 15 ist ein Laserstrahl versinnbildlicht, der sowohl durch die Schutzschicht 7 als auch durch die Prepreg-Schicht 14, die eine Isolierschicht darstellt, bis zum Auftreffen auf eine Laserstopplage 16, beispielsweise aus Kupfer, schneidet. Mit 17 ist eine haftvermindernde Schicht bezeichnet, die die Herauslösung des mittels des Laserstrahls 15 geschnittenen Pfropfens 18 erleichtert (Fig. 2b)). Der Zustand in Fig. 2b entspricht prinzipiell dem Zustand der Leiterplatte in Fig. 1c) und es ist offensichtlich, dass die weitere Bearbeitung und die Herstellung der verspiegelten Kavität analog den Verfahrensschritten 1d) bis 1f) erfolgen kann, sodass letztendlich eine bestückte Leiterplatte wie in Fig. 2c) ersichtlich erhalten werden kann.

Es ist offensichtlich, dass die vorliegende Erfindung nicht nur im Zusammenspiel mit LED-Chips eingesetzt werden, sondern auch für andere optoelektronische Komponenten, wie zum Beispiel für Photodioden oder Laserdioden ggf. zusammen mit einem Lichtkonversionsmittel, von Nutzen sein kann.

## Patentansprüche

1. Verfahren zur Herstellung einer Leiterplatte mit zumindest einer Kavität zur Aufnahme einer optoelektronischen Komponente, wobei die Kavitätenwände eine reflektierende, insbesondere spiegelnde Reflektorschicht aufweisen, mit den folgenden Schritten:
- Bereitstellen einer Leiterplatte (1),
- Aufbringen einer temporären Schutzschicht (7) auf zumindest einen Teilbereich der Oberfläche der Leiterplatte (1),
- Herstellen der Kavität (9) unter Durchdringung der Schutzschicht (7) im Bereich der Kavität (9),
- Aufbringen der Reflektorschicht (11), wobei die Reflektorschicht (11) sowohl die temporäre Schutzschicht (7) als auch die Kavitätenwände (10) flächig bedeckt, und
- Entfernen der temporären Schutzschicht (7).

2. Verfahren nach Anspruch 1, **dadurch gekennzeichnet, dass** eine Leiterplatte (1) mit strukturierten Bondoberflächen (5) für elektronische Komponenten (12) bereitgestellt wird.

3. Verfahren nach Anspruch 1 oder 2, **dadurch gekennzeichnet, dass** als Leiterplatte (1) eine IMS-Leiterplatte (1) bereitgestellt wird.

4. Verfahren nach einem der Ansprüche 1 bis 3, **dadurch gekennzeichnet, dass** der Schritt des Herstellens der Kavität (9) das Fräsen der Leiterplatte (1) mit einem Fräskopf (8) umfasst.

5. Verfahren nach Anspruch 1 oder 2, **dadurch gekennzeichnet, dass** als Leiterplatte (1) eine Leiterplatte (1) aus einem Prepreg-Material bereitgestellt wird.

6. Verfahren nach Anspruch 5, **dadurch gekennzeichnet, dass** der Schritt des Herstellens der Kavität (9) das Schneiden der Leiterplatte (1) mit einem Laserstrahl (15) umfasst.

7. Verfahren nach einem der Ansprüche 1 oder 2, **dadurch gekennzeichnet, dass** die Leiterplatte (1) eine über einer Laserstopplage (16) angeordnete haftvermindernde Schicht (17) aufweist.

8. Verfahren nach einem der Ansprüche 1 bis 7, **dadurch gekennzeichnet, dass** als temporäre Schutzschicht (7) eine selbstklebende Folie aufgebracht wird.

9. Verfahren nach Anspruch 8, **dadurch gekennzeichnet, dass** die selbstklebende Folie eine Folie auf Polyethylenbasis mit einer Klebeschicht auf Kautschukbasis ist.

10. Verfahren nach Anspruch 8, **dadurch gekennzeichnet, dass** die selbstklebende Folie eine Folie auf PVC-Basis mit einer Klebeschicht auf Acrylatbasis ist.

11. Verfahren nach Anspruch 8, **dadurch gekennzeichnet, dass** die selbstklebende Folie eine Folie auf Polyethylenbasis mit einer Klebeschicht auf Acrylatbasis ist.

12. Verfahren nach einem der Ansprüche 1 bis 7, **dadurch gekennzeichnet, dass** als temporäre Schutzschicht (7) ein Lack auf Silikonbasis aufgebracht wird.

13. Verfahren nach einem der Ansprüche 1 bis 12, **dadurch gekennzeichnet, dass** die Reflektorschicht (11) aus einem Lack, ausgewählt aus der Gruppe bestehend aus Epoxidlacken und Acrylatlacken, gebildet wird.

14. Verfahren nach einem der Ansprüche 1 bis 12, **dadurch gekennzeichnet, dass** die Reflektorschicht (11) als Metallschicht aus den Metallen ausgewählt aus der Gruppe bestehend aus Al, Ag und Rh auf die Leiterplatte aufgebracht wird.

15. Verfahren nach Anspruch 14, **dadurch gekennzeichnet, dass** zusätzlich eine Schicht ausgewählt aus der Gruppe bestehend aus Siliziumoxid und Aluminiumoxid aufgebracht wird.

16. Verfahren nach einem der Ansprüche 1 bis 12, **dadurch gekennzeichnet, dass** der Schritt des Aufbringens der Reflektorschicht (11) die folgenden Schritte umfasst:
- Lackieren der Kavität (9) mit einem Glanzlack,
- Aufbringen einer Reflexionsschicht aus Metall auf den Glanzlack,
- Aufbringen einer Schutzschicht auf Hexamethylsiloxanbasis auf die Reflexionsschicht.

17. Verfahren nach einem der Ansprüche 1 bis 16, **dadurch gekennzeichnet, dass** beim Schritt des Herstellens der Kavität (9) Abstand zu bestehenden Leiterzügen (4) bzw. Bondoberflächen (5) der Leiterplatte (1) gehalten wird.

## Claims

1. Method for producing a printed circuit board having at least one cavity for accommodating an optoelectronic component, the cavity walls having a reflective, in particular specular, reflector layer, having the following steps:
- providing a printed circuit board (1),
- applying a temporary protective layer (7) to at least a partial area of the surface of the printed circuit board (1),
- making the cavity (9) with penetration of the protective layer (7) in the region of the cavity (9),
- applying the reflector layer (11), wherein the reflector layer (11) covers both the temporary protective layer (7) and the cavity walls (10) over the entire surface, and
- removing the temporary protective layer (7).

2. Method according to claim 1, **characterized in that** a printed circuit board (1) with structured bonding surfaces (5) for electronic components (12) is provided.

3. Method according to claim 1 or 2, **characterized in that** as printed circuit board (1) an IMS printed circuit board (1) is provided.

4. Method according to any one of claims 1 to 3, **characterized in that** the step of producing the cavity (9) comprises milling the printed circuit board (1) with a milling head (8).

5. Method according to claim 1 or 2, **characterized in that** as a printed circuit board (1) a printed circuit board (1) made of a prepreg material is provided.

6. Method according to claim 5, **characterized in that** the step of producing the cavity (9) comprises cutting the printed circuit board (1) with a laser beam (15).

7. Method according to one of claims 1 or 2, **characterized in that** the printed circuit board (1) comprises an adhesion-reducing layer (17) arranged above a laser stop layer (16).

8. Method according to one of claims 1 to 7, **characterized in that** a self-adhesive film is applied as temporary protective layer (7).

9. Method according to claim 8, **characterized in that** the self-adhesive film is a polyethylene-based film with a rubber-based adhesive layer.

10. Method according to claim 8, **characterized in that** the self-adhesive film is a PVC-based film with an acrylate-based adhesive layer.

11. Method according to claim 8, **characterized in that** the self-adhesive film is a polyethylene-based film with an acrylate-based adhesive layer.

12. Method according to any one of claims 1 to 7, **characterized in that** a silicone-based varnish is applied as temporary protective layer (7).

13. Method according to one of claims 1 to 12, **characterized in that** the reflector layer (11) is formed from a lacquer selected from the group consisting of epoxy lacquers and acrylate lacquers.

14. Method according to any one of claims 1 to 12, **characterized in that** the reflector layer (11) is applied to the printed circuit board as a metal layer of the metals selected from the group consisting of Al, Ag and Rh.

15. Method according to claim 14, **characterized in that** a layer selected from the group consisting of silicon oxide and aluminum oxide is additionally applied.

16. Method according to any one of claims 1 to 12, **characterized in that** the step of ringing the reflector layer (11) comprises the following steps:
- Painting the cavity (9) with a gloss paint,
- Applying a reflective layer of metal to the glossy lacquer,
- applying a hexamethylsiloxane-based protective layer to the reflective layer.

17. Method according to one of claims 1 to 16, **characterized in that** during the step of producing the cavity (9), distance is maintained from existing conductor tracks (4) or bond surfaces (5) of the printed circuit board (1).

## Revendications

1. Procédé de fabrication d'une carte de circuit imprimé comportant au moins une cavité destinée à recevoir un composant optoélectronique, les parois de la cavité présentant une couche réfléchissante, en particulier spéculaire, comportant les étapes suivantes :
- fournir une carte de circuit imprimé (1),
- appliquer une couche de protection temporaire (7) sur au moins une région partielle de la surface de la carte de circuit imprimé (1),
- fournir à la cavité (9) une pénétration de la couche protectrice (7) dans la région de la cavité (9),
- appliquer la couche réflectrice (11), la couche réflectrice (11) recouvrant la surface à la fois de la couche protectrice temporaire (7) et des parois de la cavité (10), et
- enlever la couche de protection temporaire (7).

2. Procédé selon la revendication 1, **caractérisé en ce qu'**une carte de circuit imprimé (1) avec des surfaces de liaison structurées (5) pour des composants électroniques (12) est fournie.

3. Procédé selon la revendication 1 ou 2, **caractérisé en ce qu'**une carte de circuit imprimé IMS (1) est prévue comme carte de circuit imprimé (1).

4. Procédé selon l'une quelconque des revendications 1 à 3, **caractérisé en ce que** l'étape de production de la cavité (9) comprend le fraisage de la carte de circuit imprimé (1) avec une tête de fraisage (8).

5. Procédé selon la revendication 1 ou 2, **caractérisé en ce qu'**une carte de circuit imprimé (1) faite d'un matériau préimprégné est fournie comme carte de circuit imprimé (1).

6. Procédé selon la revendication 5, **caractérisé en ce que** l'étape de production de la cavité (9) comprend la découpe de la carte de circuit imprimé (1) avec un faisceau laser (15).

7. Procédé selon l'une des revendications 1 ou 2, **caractérisé en ce que** la carte de circuit imprimé (1) comprend une couche de réduction d'adhérence (17) disposée au-dessus d'une couche d'arrêt laser (16).

8. Procédé selon l'une quelconque des revendications 1 à 7, **caractérisé en ce qu'**un film auto-adhésif est appliqué comme couche protectrice temporaire (7).

9. Procédé selon la revendication 8, **caractérisé en ce que** le film auto-adhésif est un film à base de polyéthylène avec une couche adhésive à base de caoutchouc.

10. Procédé selon la revendication 8, **caractérisé en ce que** le film auto-adhésif est un film à base de PVC avec une couche adhésive à base d'acrylate.

11. Procédé selon la revendication 8, **caractérisé en ce que** le film auto-adhésif est un film à base de polyéthylène avec une couche adhésive à base d'acrylate.

12. Procédé selon l'une quelconque des revendications 1 à 7, **caractérisé en ce qu'**un vernis à base de silicone est appliqué comme couche protectrice temporaire (7).

13. Procédé selon l'une quelconque des revendications 1 à 12, **caractérisé en ce que** la couche réflectrice (11) est formée d'une laque choisie dans le groupe constitué par les laques époxy et les laques d'acrylate.

14. Procédé selon l'une quelconque des revendications 1 à 12, **caractérisé en ce que** la couche de réflecteur (11) est appliquée sur la carte de circuit imprimé en tant que couche métallique des métaux choisis dans le groupe constitué par Al, Ag et Rh.

15. Procédé selon la revendication 14, **caractérisé en ce qu'**on applique en plus une couche choisie dans le groupe constitué par l'oxyde de silicium et l'oxyde d'aluminium.

16. Procédé selon l'une quelconque des revendications 1 à 12, **caractérisé en ce que** l'étape de cerclage de la couche réflectrice (11) comprend les étapes suivantes :
- Peindre la cavité (9) avec une peinture brillante,
- l'application d'une couche de métal réfléchissant sur la laque brillante,
- l'application d'une couche protectrice à base d'hexaméthylsiloxane sur la couche réfléchissante

17. Procédé selon l'une des revendications 1 à 16, **caractérisé en ce que** pendant l'étape de réalisation de la cavité (9), on maintient une distance par rapport aux pistes conductrices (4) ou aux surfaces de liaison (5) existantes de la carte de circuit imprimé (1).
